# EUROPEAN PATENT APPLICATION

(11) **EP 4 542 858 A1**
(43) Date of publication of application: **23.04.2025**
(21) Application number: 24205345.2
(22) Date of filing: 08.10.2024
(51) Int. Cl.: H03K 5/24, G01R 31/317, G06F 7/02, H03K 19/173, H03K 19/17764

(54) **SYSTEM AND METHOD OF FLEXIBLE COMPARATOR RECONFIGURATION TO IMPROVE COMPARATOR AVAILABILITY**

(30) Priority: 20.10.2023 IN 202341071684
(71) Applicant: NXP B.V., 5656 AG Eindhoven (NL)
(72) Inventor: Muddaiah, Arjun, 5656AG Eindhoven (NL); Kumar, Ashish, 5656AG Eindhoven (NL)
(74) Representative: Miles, John Richard

(57) **Abstract**

A processing system (100) including multiple devices (104) each providing a data set, multiple comparators (CMP1-CMPN) each operative to compare a selected pair of data sets, multiple multiplexers (MUX1-MUXN) each for selecting from among coupled data sets and providing selected data sets to inputs of corresponding comparators (CMP1-CMPN), and a comparator configuration controller (118) that controls each the multiplexers to select pairs of data sets provided to the corresponding comparators. The multiplexers provide flexible comparator reconfiguration for improved comparator availability. In the event of failure of a device (104: D1-DM) using a comparator, the controller (118) reconfigures the corresponding multiplexer to re-use the comparator for a similar or different comparison configuration. Data latch buffers (110) and configurable delay gates (112) may be provided between the multiplexers (MUX1-MUXN) and the comparators (CMP1-CMPN). The buffers (110) may have ports available to be loaded by software. Clock multiplexers (116) may be provided to select a clock signal (CC1-CCN) for each comparator (CMP1-CMPN) based on usage.

## Description

### FIELD

The present invention relates in general to comparator availability, and more particularly to system and method of dynamic comparator reconfiguration to improve comparator availability.

### DESCRIPTION OF THE RELATED ART

In conventional configurations, each comparator that was configured to compare results of a specific pair of devices became extraneous and unusable in the event of failure of either of the device. For example, data comparators may be used to perform data comparisons in a lockstep configuration between lockstep devices, such as processing cores or direct memory access (DMA) controllers or the like. In the event of lockstep failure due to fault of one of the devices, the failed device was halted, the operating device could be switched to split-lock mode, and the comparator was left inoperable given that there was no possibility to use the dedicated data comparator for other functionality in the system. Also, there were no flexible comparators that could be extended or made available for other safety elements operating according to specified safety protocols, such as, for example, the automotive safety integrity level (ASIL) used by many automotive applications. Instead, limited operation was often resumed through software methods which are notoriously quite slow in performance.

### BRIEF DESCRIPTION OF THE DRAWINGS

Embodiments of the present invention are illustrated by way of example and are not limited by the accompanying figures. Similar references in the figures may indicate similar elements. Elements in the figures are illustrated for simplicity and clarity and have not necessarily been drawn to scale.
FIG. 1 is a simplified block diagram of a processing system including a flexible comparator configuration system implemented according to one embodiment.
FIG. 2 is a simplified block diagram of a portion of the flexible comparator configuration system of FIG. 1 used as a flexible lock-step configuration according to one embodiment.
FIG. 3 is a simplified block diagram of a portion of the flexible comparator configuration system of FIG. 1 used as a flexible comparison configuration according to one embodiment.
FIG. 4 is a simplified block diagram of digital converter circuitry which may be used to implement the converter circuitry of FIG. 3 according to one embodiment configurable by the comparator configuration controller of FIG. 1.

### DETAILED DESCRIPTION

The present disclosure describes a system and method of dynamic comparator reconfiguration to improve comparator availability. An array of devices each provide output values that may be compared with the output values of another device. An array of multiplexers each select the output values of a pair of devices to be compared by a corresponding one of an array of comparators. A routing matrix routes the output values of each device to the inputs of at least one of the multiplexers based on functional safety need and enable availability, which usually includes two or more of the multiplexers. The output values of each device, however, need not be routed to each multiplexer and corresponding comparator to reduce routing complexity. A comparator configuration controller may be used to configure and initialize each device and to configure each multiplexer to select the outputs of a pair of devices for comparison. An array of clock multiplexers may be included so that the comparator configuration controller may select a suitable clock signal for each of the comparators depending upon inputs selected for the respective comparator.

A data latch buffer and a configurable delay gate may be provided between each output of each multiplexer and each corresponding input of a corresponding comparator for purposes of synchronization. The data latch buffers may provide a signal through the multiplexer back to the device indicating that the buffer is full to prevent overflow when the devices are operating a different speeds. Additionally, the data latch buffers may be accessible to software to facilitate software-based comparisons. For software-based comparisons, for example, the software can manually write into each data latch buffer as a register interface and manually trigger a comparison by the corresponding comparator by setting a trigger signal. For hardware-based comparisons, the trigger signal can be set once the output data of both devices are latched to initiate the comparison.

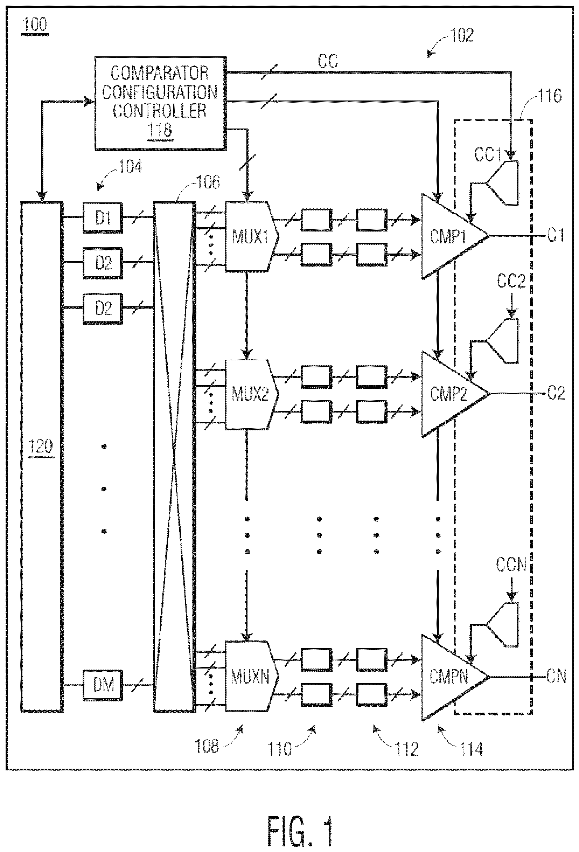

FIG. 1 is a simplified block diagram of a processing system 100 including a flexible comparator configuration system 102 implemented according to one embodiment. The processing system 100 includes a set of M devices 104 for performing various functions of the processing system 100, in which "M" is a positive integer. The devices 104 may include, for example, processing cores, direct memory access (DMA) engines, bus devices, memory devices, communication devices, peripherals, etc. Each of the devices 104 provide a data set of output values in which each data set includes at least one digital value, at least one analog value, or a combination of both. The data sets from a selected pair of devices may be compared for making decisions or for determining correct operation. Comparisons may include cyclical redundancy check (CRC) data comparison of DMA channel, memory, flash, or communication peripherals, etc., along with trigger-based software comparison of memory data, register data, CRC results, etc. The flexible comparator configuration system 102 includes a routing matrix 106, an array of N multiplexers (MUXes) 108, an array of 2N data latch buffers (DLBs) 110, an array of 2N configurable delay gates (CDGs) 112, an array of N comparators 114, an array of N clock MUXes 116, and a comparator configuration controller 118, in which "N" is a positive integer that may or may not be equal to M.

The processing system 100 includes a communication bus 120 coupled to each of the set of devices 104 that enables configuration and timing control by the comparator configuration controller 118 as further described herein. The data sets provided by the devices 104 are provided through the routing matrix 106 to corresponding inputs of one or more of the MUXes 108. Although it is possible to route the data set of each of the devices 104 to a corresponding input of each of the MUXes 108 through the routing matrix 106, such comprehensive routing structure can be excessive and is not necessary for most configurations. Instead, the data set of each of the devices 104 may be routed to at least one and usually a subset of the MUXes 108, such as two or three of the MUXes 108, to achieve an acceptable level of operation. Such routing can be limited, for example, to safety relevant devices and the number of comparators for each device can be decided based on relevant safety standards and various failure modes of the safety elements.

Each of the MUXes 108 is shown configured as a P:2 MUX with P inputs and 2 outputs in which "P" is a positive integer. It is noted, however, that one or more of the MUXes 108 may have more or less than P inputs. For example, many of the MUXes 108 may have less than P inputs to reduce routing. In addition, although P may be equal to M (so that the data set of each of the M devices is routed to an input of each of the MUXes 108), in many practical configurations P is less than M to reduce routing. Each MUX 108 input is a data set from a corresponding one of the devices 104 and each output is a selected one of the input data sets as controlled by the comparator configuration controller 118. The comparator configuration controller 118 controls each of the MUXes 108 for selecting a pair of MUX inputs to be provided to the corresponding pair of MUX outputs. The pair of outputs of each of the MUXes 108 is provided through a corresponding pair of the DLBs 110, through a corresponding pair of the CDGs 112, and to the pair of inputs of a corresponding one of the comparators 114. The comparators 114 includes an integer number N comparators individually labeled CMP1, CMP2, ..., CMPN (CMP1 - CMPN) providing a corresponding set of N output signals C1, C2, ..., CN (C1 - CN). The comparator configuration controller 118 may control one or more parameters of each of the comparators 114 as further described herein. The array of clock MUXes 116 includes one clock MUX 116 for each of the comparators 114, in which each clock MUX is controlled by the comparator configuration controller 118 via a corresponding one of N clock control (CC1 - CCN) signals for selecting from among multiple clock signals to provide a selected clock signal to a clock input of a corresponding comparator.

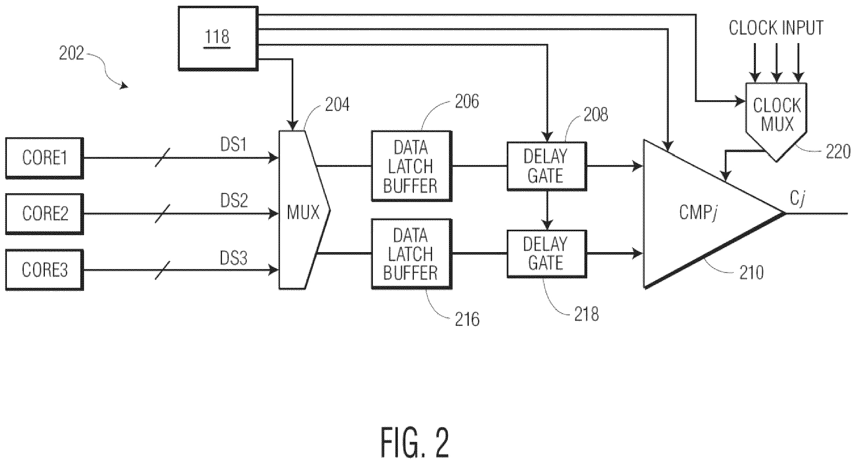

FIG. 2 is a simplified block diagram of a portion of the flexible comparator configuration system 102 used as a flexible lock-step configuration 202 according to one embodiment. The routing matrix 106 may be included but is not shown. The set of devices 104 includes a first processing core CORE1, a second processing core CORE2, and a third processing core CORE3, which are each implemented and configured in substantially similar manner. CORE3 represents any number of additional processing cores that are provided to perform various independent functions or that may be placed in standby mode at any given time. Although not specifically shown, the comparator configuration controller 118 (or other control circuitry) initially configures CORE1 and CORE2 for lock-step (LS) operation, in which each executes the instructions of the same application at substantially the same time. CORE1 operates as a master core that generates and provides a first data set of digital signals DS1 to a first input of a MUX 204 which is one of the MUXes 108. CORE2 initially operates as a monitoring core that generates and provides a second data set of digital signals DS2 to a second input of the MUX 204.

The comparator configuration controller 118 controls the MUX 204 to select DS1 as a first output of the MUX 204, in which the data set DS1 is provided through a DLB 206 being a corresponding one of the DLBs 110, then through a CDG 208 being a corresponding one of the CDGs 112, and then to a first input of a comparator 210, which is the jth one of the comparators 116 (or CMPj in which j is an index from 1 to N) and which outputs a compare signal Cj. The comparator configuration controller 118 also controls the MUX 204 to select DS2 as a second output of the MUX 204, in which the data set DS2 is provided through a DLB 216 being a corresponding one of the DLBs 110, then through a CDG 218 being a corresponding one of the CDGs 112, and then to a second input of the comparator 210. The DLBs 206 and 216 are essentially synchronized with each other and may operate using the same clock. In addition, the comparator configuration controller 118 configures the comparator 210 according to LS operation, may program the CDG 208 to have zero delay, and may program the CDG 218 to have at least one clock cycle delay. The comparator configuration controller 118 may further assert a select input to a clock MUX 220, being a corresponding one of the clock MUXes 116, so that the comparator 210 is synchronized with CORE1 and CORE2. Generally, DS2 is intended to be an identical but delayed version of DS1, in which the comparator 210 compares corresponding cycles of DS1 with DS2 for generating Cj.

During normal LS operation, the comparator 210 asserts Cj to a first state while each comparison between DS1 and delayed DS2 are the same indicating successful LS operation. In the event Cj transitions to a second state indicating that LS operation has failed (either a first occurrence or after a programmable number of indications), LS operation is suspended, the applicable cores CORE1 and CORE2 are reconfigured into a split-lock mode for independent operation, and a test procedure is performed to determine which of the processing cores CORE1 or CORE2 has failed or is faulty. Suppose, for example, that CORE2 is determined to have failed. The application being executed in LS operation mode is typically a critical function for meeting applicable safety standards, such that in conventional configurations, the processing system 100 may have to be shut down or at least operated in degraded mode until the faulty condition is resolved.

The flexible lock-step configuration 202 of the flexible comparator configuration system 102, however, enables operation to resume while also meeting the applicable safety standards. In this case, CORE3 also has its data set DS3 routed to an input of the MUX 204 via the routing matrix 106. The comparator configuration controller 118 reconfigures CORE3 in LS operation with CORE1 in which CORE3 essentially replaces CORE2. CORE3 is reconfigured as the monitoring core so that CORE1 and CORE3 are restarted in LS operation in which each executes the instructions of the same application at substantially the same time. Again, CORE1 operates as a master core providing DS1 to a first input of the MUX 204, while CORE3 operates as a monitoring core that generates and provides DS3 to a second input of the MUX 204. The comparator configuration controller 118 controls the MUX 204 to select DS3 as the second output of the MUX 204, in which the data set DS3 is provided through DLB 216 and through CDG 218 to the second input of the comparator 210. Any adjustment of the clock MUX 220 may also be made to synchronize operation.

It is noted that if instead CORE1 had failed or proved to be faulty during the test procedure, then the comparator configuration controller 118 may instead perform a substantially similar procedure except replacing CORE1 with CORE3 as the master core. Alternatively, CORE2 could be switched to operate as the master core while CORE3 is invoked to operate as the monitoring core with any appropriate adjustment of DLG 208 or 218 to ensure proper LS operation. In any of these cases, by enabling flexible reconfiguration of the comparator 210 and available devices, rather than having to shut down the processing system 100 or at least operating the processing system 100 in degraded mode, operation is only temporarily interrupted to reconfigure inputs to the comparator 210 to resume normal operation.

Although a lockstep configuration is shown for different processing cores, lockstep operation is applicable for other types of devices, such as, for example, DMA engines or the like. In the event of failure of a device in a lockstep configuration, the lockstep configuration may be restarted with the comparator using another available device, or the comparator may be extended to be used to meet other comparison needs.

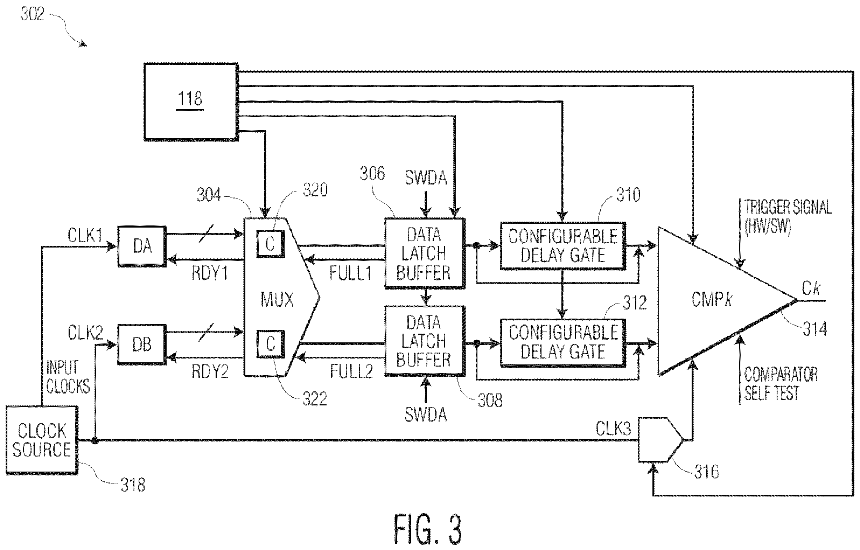

FIG. 3 is a simplified block diagram of a portion of the flexible comparator configuration system 102 used as a flexible comparison configuration 302 according to one embodiment. The routing matrix 106 may be included but is not shown. A first device DA and a second device DB are selected from the set of devices 104, in which it is desired to compare the data sets generated by the devices DA and DB. The devices DA and DB are of the same type of several different device types, such as processing cores, DMA engines, bus devices or controllers, memory devices or controllers, communication devices, peripherals, registers, etc. The data of the data sets to be compared may be status signals, control signals, CRC data, DMA channel parameters, DMA channel data, register contents, memory stored data, etc. Although not specifically shown, the comparator configuration controller 118 may initially communicate with the devices DA and DB for control, configuration, synchronization, etc., to initialize comparison operations. The configuration 302 further includes a MUX 304 which is one of the MUXes 108, a corresponding pair of DLBs 306 and 308 from the array of DLBs 110, a corresponding pair of CDGs 310 and 312 from the array of DCGs 112, a comparator 314, which is the kth one of the comparators 116 (or CMPk in which k is an index from 1 to N), and a clock MUX 316, which is a corresponding one of the clock MUXes 116. The comparator 314 outputs a compare signal Ck.

The comparator configuration controller 118 controls the MUX 304 to select the data set of DA as a first output and to select the data set of DB as a second output of the MUX 304. The first data set output of the MUX 304 from DA is provided through DLB 306 and CDG 310 to the first input of the comparator 314. The second data set output of the MUX 304 from DB is provided through DLB 308 and CDG 312 to the second input of the comparator 314. A clock source 318 is shown providing a first clock signal CLK1 to DA, a second clock signal CLK2 to DB, and a third clock signal CLK3 to an input of the clock MUX 316. Even when the different clock signals are generated from the same source, they may be skewed relative to each other by the time they reach their respective destinations. In addition, the different clock signals may not have the same frequency. For example, CLK1 may have a frequency of 100 megahertz (MHz) whereas CLK2 may have a frequency of 200 MHz, in which DB operates at a faster rate than DA.

Various features are provided to ensure synchronized comparisons by the comparator 314. Each of the DLBs 306 and 308 provides a FULL indicator signal, which is provided as, or converted to a READY signal back to the corresponding device. Each FULL signal may be provided as the same READY signal as one of the data values between the devices and the MUX 304, or may be separate signal provided to separate circuitry within the MUX 304 and converted to the READY signal. As shown, DLB 306 provides a signal FULL1 back to the MUX 304, which is provided as or otherwise converted to a signal RDY1 to DA. Similarly, DLB 308 provides a signal FULL2 back to the MUX 304, which is provided as or otherwise converted to a signal RDY2 to DB. When one of the devices DA or DB is operating faster and thus filling the corresponding DLB 306 or 308 at a faster rate, the corresponding RDY1 or RDY2 signal is used to prevent overflow of either of the data buffers. DLB 306 and 308 may operate with the same clock signal and be synchronized with each other and triggered by the comparator configuration controller 118 to deliver corresponding data to the corresponding CDGs 310 and 312 at the same time.

The comparator configuration controller 118 controls the CDGs 310 and 312 to each have the same delay or to have different delays depending upon the implementation. Each of the CDGs 310 and 312 may be configured in bypass mode for zero delay. The programmable CDGs 310 and 312 helps not only for temporal independence for comparison but the gates may also be programmed for providing necessary delay cycles to synchronize between the safety device inputs as the safety inputs may run at different clock frequencies.

In one embodiment, the comparator 314 incorporates an array of digital or binary comparators that each perform binary comparisons. In that case the compare signal Ck may represent a comprehensive result of all such individual comparisons in which Ck is asserted to a first state when all comparisons are equal or is asserted to a second state when any one comparison is not equal.

As previously stated, the devices DA and DB are of the same type of several different device types in which each device type may have a data set with a different number of signals or values. When the data set values are digital values for digital comparison by the comparator 314, then the different device types may have a different number of digital outputs. For example, processing cores may have a data set with 100 or so digital output values, whereas DMA controllers have a data set with 50 or so digital output values. The MUX 304 is configured to include a maximum number of digital input and output values for those devices (e.g., cores) having the maximum number of digital output values. When different devices are selected having a data set with less digital output values than the maximum number, then many of the digital signals are unused. In one embodiment, each of the digital output values of each of the MUXes 108 has a default Boolean logic value, such as logic 0 or logic 1. Thus, when data sets with less than the maximum number of digital input and output values are to be compared, then the unused values default to the same Boolean logic value to ensure accurate comparison.

In one embodiment, the MUX 304 may include converter circuitry 320 and 322 for each MUX output that is programmed by the comparator configuration controller 118 to convert the input data set to a corresponding output data set. For digital data sets, the number of digital output values is based on the number of operative bits for a given device type. For example, when the MUX 304 includes 100 digital input and output values and DA and DB only have 50 output values, then the converter circuitry 320 and 322 may be programmed by the comparator configuration controller 118 to force the unused digital values to a predetermined logic state, such as, for example, logic zero. Since the unused digital values are forced to have the same logic state, then the unused digital values do not affect the comparison output intended to compare data sets with less than the maximum number.

Analog comparisons are also contemplated. The devices DA and DB may output an analog signal for comparison, in which the converters 320 and 322 may instead be configured as analog-to-digital converters (ADCs). The MUX 304 outputs a pair of converted digital values for comparison by the comparator 314.

The comparison can be initiated using a trigger signal provided to the MUX 314 either through a software request or a request based in hardware, such as from the comparator configuration controller 118. As shown, each of the DLBs 306 and 308 may have a direct access port SWDA accessible by software for software-based comparisons. In this manner, the software can manually write into each of the DLBs 306 and 308 as a register interface, and manually trigger a comparison by setting the trigger signal provided to the comparator 314. For hardware-based comparisons, the trigger signal can be set by a hardware device (or the comparator configuration controller 118) once the data is latched for each MUX 304 (e.g., DMA channel completion) indicating that data can be compared at that time.

It is noted that any of the comparators 114 can compare the stored CRC (from a master) with a calculated CRC (by a target device). To ensure data integrity from a master (e.g., CPU or DMA) to a target device (e.g., memory, flash, SPI, CAN, etc.), typically the master calculates CRC over the data to be sent and stores calculated CRC in known location or appends it as extension of a data packet. The target device calculates the received data, re-performs the CRC calculation, and compares against the master calculated CRC. For example, to ensure integrity of transferred data, a DMA device provides a provision to calculate CRC for every data being transferred. For example, the DMA device may be used to move 10 bytes in which CRC is calculated and stored for the 10 bytes. Another device can calculate the received data and compare against the stored CRC value to ensure that the data was not corrupted during the transfer. The source computed CRC (DMA device) and the receiver computed CRC can be provided as inputs to the comparator either as purely hardware-based inputs or as purely software-based inputs or as a combination of both.

In addition, software can directly write into any of the DLBs 110 to trigger comparison. This offloads the comparison operation to be done in software which could reduce the wiring burden of the routing matrix 106 between the devices 104 and the MUXes 108 for coupling selected devices to selected comparators. In this manner, each of the comparators 114 may be used to perform necessary comparisons instead of sitting idle after failure of an initially-intended use.

The comparator 314 may also include an input for receiving a comparator self-test signal for latent fault coverage to ensure that the comparator 314 is operating correctly. If self-test of a comparator fails, or generally, if any comparison of selected inputs fails, the comparator raises an error in the form of an error signal or an alarm signal or the like. An appropriate error handler or alarm handler or the like determines the appropriate response usually including notification.

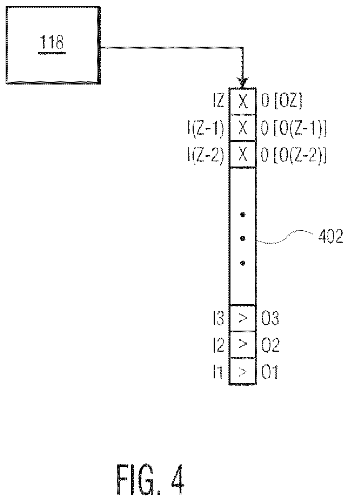

FIG. 4 is a simplified block diagram of digital converter circuitry 402 which may be used to implement the converter circuitry 320 and 322 according to one embodiment configurable by the comparator configuration controller 118. In this case, the maximum number of digital inputs and outputs of any given data set is an integer value "Z", in which the inputs range from I1 to IZ (I1, I2, I3, ... IZ) and the corresponding outputs range from O1 to OZ (O1, O2, O3, ..., OZ). Each of the Z bits of the digital converter circuitry 402 is represented as a box with an internal symbol indicating status, in which a forward arrowhead ">" denotes that the bit is enabled, or an "X" which denotes that the bits is disabled. When enabled, as indicated by the first 3 bits, then the input value is passed as the output value. Thus, 11 is passed to O1 (or O1 = I1), 12 is passed to O2 (or O2 = I2), 13 is passed to O3 (or O3 = I3), and so on. When disabled, as indicated by the last three bits, then the output value is set to a predetermined bit regardless of the input. Thus, the last three outputs O(Z-2), O(Z-1), and OZ are each zero regardless of the values of the corresponding input bits I(Z-2), I(Z-1), and IZ, respectively. In this manner, the comparator configuration controller 118 can select the number of bits of an applicable data set based on the number of data set values of a selected one of the devices 104 to enable accurate comparisons.

A processing system including multiple devices each providing a data set, multiple comparators each operative to compare a selected pair of data sets, multiple multiplexers each for selecting from among coupled data sets and providing selected data sets to inputs of corresponding comparators, and a comparator configuration controller that controls each the multiplexers to select pairs of data sets provided to the corresponding comparators. The multiplexers provide flexible comparator reconfiguration for improved comparator availability. In the event of failure of a device using a comparator, the controller reconfigures the corresponding multiplexer to re-use the comparator for a similar or different comparison configuration. Data latch buffers and configurable delay gates may be provided between the multiplexers and the comparators. The buffers may have ports available to be loaded by software. Clock multiplexers may be provided to select a clock signal for each comparator based on usage.

Aspects of the disclosure are defined in the accompanying claims. In a first aspect, there is provided a processing system, comprising: a plurality of devices, each configured to provide a corresponding one of a plurality of data sets; a plurality of comparators, each having a pair of inputs and each operative to compare a selected pair of the plurality of data sets; a plurality of multiplexers, each having a plurality of inputs for receiving selected ones of the plurality of data sets, and each having a pair of outputs for providing a selected pair of the plurality of data sets to a pair of inputs of a corresponding one of the plurality of comparators; and a comparator configuration controller that is configured to control each of the plurality of multiplexers to select a pair of data sets provided to the inputs of the multiplexer as the selected pair of data sets provided to a corresponding one of the plurality of comparators.

In some embodiments, the processing system further comprises a routing matrix that routes the data set of each of the plurality of devices to an input of at least one of the plurality of multiplexers. In some embodiments, the plurality of devices includes a plurality of processing cores. In some embodiments, the processing system further comprises a plurality of data latch buffers, each coupled between an output of one of the plurality of multiplexers and an input of a corresponding one of the plurality of comparators. In some embodiments, at least one of the plurality of data latch buffers comprises a direct access port accessible to software. In some embodiments, at least one of the plurality of data latch buffers provides a full indication. In some embodiments, the processing system further comprises a plurality of configurable delay gates, each coupled between an output of one of the plurality of multiplexers and an input of a corresponding one of the plurality of comparators, and each programmable by the comparator configuration controller to program a delay. In some embodiments, the processing system further comprises a plurality of clock multiplexers each controlled by the comparator configuration controller to select from among a plurality of clock signals to provide a selected clock signal to a clock input of a corresponding one of the plurality of comparators. In some embodiments, at least one of the plurality of comparators comprises converter circuitry for converting a data set input to a data set output. In some embodiments, the converter circuitry comprises an analog to digital converter. In some embodiments, the converter circuitry comprises a digital converter that passes used values and that forces unused values to a predetermined logic value. In some embodiments, at least one of the plurality of comparators comprises a trigger input receiving a trigger signal from hardware or software to initiate a comparison.

In some embodiments, at least one of the plurality of comparators is configured with self-test circuitry coupled to a self-test input for testing the comparator upon receiving a self-test signal. In some embodiments, the plurality of devices comprises first and second devices of a same type coupled in a lockstep configuration with a selected one of the plurality of multiplexers and a corresponding comparator; and wherein the comparator configuration controller is configured to replace a failed one of the first and second devices with a third device of the same type coupled to an input of the selected multiplexer and to reconfigure the third device and the operative one of the first and second devices into a lockstep configuration.

In a second aspect, there is provided a method of flexible comparator reconfiguration for a processing system which includes a plurality of devices and plurality of multiplexers, wherein each device is configured to provide a corresponding one of a plurality of data sets and wherein each comparator has a pair of inputs and is operative to compare a selected pair of the plurality of data sets, the method comprising: providing a plurality of multiplexers each having a plurality of inputs for receiving selected ones of the plurality of data sets and each having a pair of outputs for providing a selected pair of the plurality of data sets to a pair of inputs of a corresponding one of the plurality of comparators; and controlling each of the plurality of multiplexers to select a pair of data sets provided to the inputs of the multiplexer as the selected pair of data sets provided to a corresponding one of the plurality of comparators.

In some embodiments, the method further comprises routing the data set of each of the plurality of devices to an input of at least one of the plurality of multiplexers. In some embodiments, the method further comprises providing a plurality of data latch buffers each coupled between an output of one of the plurality of multiplexers and an input of a corresponding one of the plurality of comparators.

In some embodiments, the method further comprises providing a direct access port to each of the plurality of data buffers accessible to software. In some embodiments, the method further comprises providing a plurality of configurable delay gates each coupled between an output of one of the plurality of multiplexers and an input of a corresponding one of the plurality of comparators.

In some embodiments, the method further comprises providing a plurality of clock multiplexers to select from among a plurality of clock signals to provide a selected clock signal to a clock input of a corresponding one of the plurality of comparators.

Although the present invention has been described in connection with several embodiments, the invention is not intended to be limited to the specific forms set forth herein. On the contrary, it is intended to cover such alternatives, modifications, and equivalents as can be reasonably included within the scope of the invention as defined by the appended claims. For example, variations of positive circuitry or negative circuitry may be used in various embodiments in which the present invention is not limited to specific circuitry polarities, device types or voltage or error levels or the like. For example, circuitry states, such as circuitry low and circuitry high may be reversed depending upon whether the pin or signal is implemented in positive or negative circuitry or the like. In some cases, the circuitry state may be programmable in which the circuitry state may be reversed for a given circuitry function.

The terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements.

## Claims

1. A processing system, comprising:
a plurality of devices, each configured to provide a corresponding one of a plurality of data sets;
a plurality of comparators, each having a pair of inputs and each operative to compare a selected pair of the plurality of data sets;
a plurality of multiplexers, each having a plurality of inputs for receiving selected ones of the plurality of data sets, and each having a pair of outputs for providing a selected pair of the plurality of data sets to a pair of inputs of a corresponding one of the plurality of comparators; and
a comparator configuration controller that is configured to control each of the plurality of multiplexers to select a pair of data sets provided to the inputs of the multiplexer as the selected pair of data sets provided to a corresponding one of the plurality of comparators.

2. The processing system of claim 1, further comprising a routing matrix that routes the data set of each of the plurality of devices to an input of at least one of the plurality of multiplexers.

3. The processing system of claim 1 or 2, wherein the plurality of devices includes a plurality of processing cores.

4. The processing system of any preceding claim, further comprising a plurality of data latch buffers, each coupled between an output of one of the plurality of multiplexers and an input of a corresponding one of the plurality of comparators.

5. The processing system of claim 4, wherein at least one of the plurality of data latch buffers comprises a direct access port accessible to software.

6. The processing system of claim 4 or 5, wherein at least one of the plurality of data latch buffers provides a full indication.

7. The processing system of any preceding claim, further comprising a plurality of configurable delay gates, each coupled between an output of one of the plurality of multiplexers and an input of a corresponding one of the plurality of comparators, and each programmable by the comparator configuration controller to program a delay.

8. The processing system of any preceding claim, further comprising a plurality of clock multiplexers each controlled by the comparator configuration controller to select from among a plurality of clock signals to provide a selected clock signal to a clock input of a corresponding one of the plurality of comparators.

9. The processing system of any preceding claim, wherein at least one of the plurality of comparators comprises converter circuitry for converting a data set input to a data set output.

10. The processing system of claim 9, wherein the converter circuitry comprises an analog to digital converter.

11. The processing system of claim 9 or 10, wherein the converter circuitry comprises a digital converter that passes used values and that forces unused values to a predetermined logic value.

12. The processing system of any preceding claim, wherein at least one of the plurality of comparators comprises a trigger input receiving a trigger signal from hardware or software to initiate a comparison.

13. The processing system of any preceding claim, wherein at least one of the plurality of comparators is configured with self-test circuitry coupled to a self-test input for testing the comparator upon receiving a self-test signal.

14. The processing system of any preceding claim, wherein:
the plurality of devices comprises first and second devices of a same type coupled in a lockstep configuration with a selected one of the plurality of multiplexers and a corresponding comparator; and
wherein the comparator configuration controller is configured to replace a failed one of the first and second devices with a third device of the same type coupled to an input of the selected multiplexer and to reconfigure the third device and the operative one of the first and second devices into a lockstep configuration.

15. A method of flexible comparator reconfiguration for a processing system which includes a plurality of devices and plurality of multiplexers, wherein each device is configured to provide a corresponding one of a plurality of data sets and wherein each comparator has a pair of inputs and is operative to compare a selected pair of the plurality of data sets, the method comprising:
providing a plurality of multiplexers each having a plurality of inputs for receiving selected ones of the plurality of data sets and each having a pair of outputs for providing a selected pair of the plurality of data sets to a pair of inputs of a corresponding one of the plurality of comparators; and
controlling each of the plurality of multiplexers to select a pair of data sets provided to the inputs of the multiplexer as the selected pair of data sets provided to a corresponding one of the plurality of comparators.
